# EUROPEAN PATENT APPLICATION

(11) **EP 4 333 030 A1**
(43) Date of publication of application: **06.03.2024**
(21) Application number: 22193335.1
(22) Date of filing: 31.08.2022
(51) Int. Cl.: H01L 21/56, H01L 23/495, H01L 23/488, H01L 23/31

(54) **ELECTRONIC PACKAGE AND MANUFACTURING METHOD THEREFOR**

(71) Applicant: Nexperia B.V., 6534 AB Nijmegen (NL)
(72) Inventor: Yandoc, Ricardo, Manchester, SK7 5BJ (GB); Anthony, Matthew, Manchester, SK7 5BJ (GB); Brown, Adam, Manchester, SK7 5BJ (GB)
(74) Representative: Pjanovic, Ilija

(57) **Abstract**

Aspects of the present disclosure generally relate to an electronic package and a method for manufacturing such electronic packages. The method includes providing a frame including a plurality of die pads, each die pad having arranged thereon a semiconductor die, the semiconductor die having a first electrical contact on a first side of the semiconductor die facing and electrically contacting the die pad, and a second electrical contact on a second side of the semiconductor die opposite to the first side, providing a first conductive mechanical support that is fixedly connected to the die pad and/or providing a second conductive mechanical support that is fixedly connected to the second electrical contact, and providing a mold comprising a first mold portion on which the frame is arranged, and a second mold portion that is brought into contact with the frame opposite to the first mold portion, the mold forming a molding cavity around the plurality of semiconductor dies, wherein the second mold portion contacts at least one of the first conductive mechanical support and the second conductive mechanical support while applying the molding compound and allowing said molding compound to solidify.

## Description

### FIELD

Aspects of the present disclosure generally relate to an electronic package and a method for manufacturing such electronic packages. The method is particularly suitable for manufacturing a plurality of electronic packages substantially simultaneously using a single molding cavity.

### BACKGROUND

Electronic packages typically comprise a semiconductor die on which a circuit is integrated, which semiconductor die is encapsulated by a package material, such as solidified molding compound, to protect said semiconductor die.

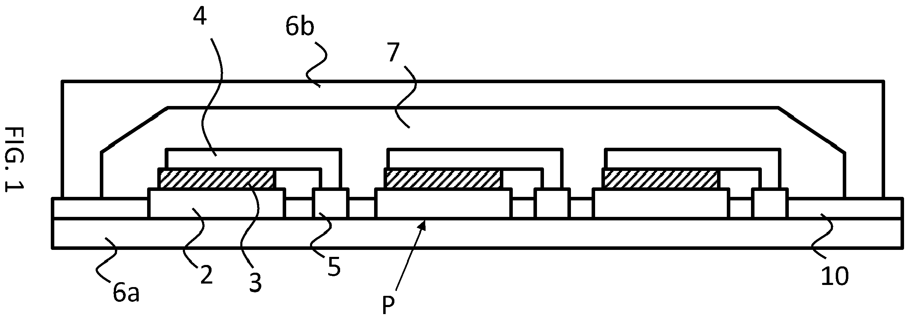

A known method of manufacturing an electronic package is illustrated using a simplified cross-sectional view in FIG. 1. The method includes providing a frame 10 including a plurality of die pads 2. On each die pad 2, a semiconductor die 3 is provided. In FIG. 1, three package portions are shown, each including a respective semiconductor die 3, that will eventually form three separate electronic packages. For convenience, reference signs are only shown for one of said package portions. It is noted that, although only three package portions are shown, the method may include more than three package portions, which may be arranged in a row or array, as will be appreciated by the skilled person.

Semiconductor die 3 includes a first electrical contact facing die pad 2, and a second electrical contact opposite the first electrical contact. Each package portion in this example further includes a clip lead 4 which is fixedly attached and electrically connected to the second electrical contact. Clip lead 4 may form a package terminal of the eventual electronic package, or may be fixedly and electrically connected to a package contact 5, for example also included in frame 10, which package contact 5 may form a package terminal of the eventual electronic package. Furthermore, in this example, die pad 2 may be conductive and may itself form a package terminal of the eventual package. In that sense, the eventual electronic package will be mountable to an external surface, such as a printed circuit board (PCB), with die pad 2 and package contact 5 facing the external surface.

A mold is provided to arrange the package material encapsulating semiconductor dies 3. For example, frame 10 is arranged on a first mold portion 6a, and a second mold portion 6b is provided contacting frame 10 to form a molding cavity 7 enclosing and surrounding the plurality of package portions. An injection molding step can then be applied to inject the package material (e.g., a molding compound) into molding cavity 7. The mold is arranged until the package material is arranged, for example until the molding compound is solidified, after which the mold can be removed.

While arranging the package material, part of the package material may leak or flow into areas such as at position P indicated in FIG. 1. Typically, in a row or array of package portions, the package portions near a middle of the row or array are particularly susceptible to thick flashes of package material forming under die pad 2 and/or package contact 5. This can be detrimental to the eventual electronic package, since die pad 2 and package contact may each form package terminals that would be obstructed by such package material. Moreover, die pad 2 may in some examples act as a heatsink for semiconductor die 3 by enabling heat to dissipate through die pad 2 to an outside of the electronic package. Any package material covering die pad 2 would decrease the effectiveness of die pad 2 as a heatsink.

### SUMMARY

Aspects of the present disclosure relate to an electronic package and manufacturing method therefor in which the abovementioned drawback(s) do not occur, or hardly so.

A summary of aspects of certain embodiments disclosed herein is set forth below. It should be understood that these aspects are presented merely to provide the reader with a brief summary of these certain embodiments and that these aspects are not intended to limit the scope of this disclosure. Indeed, this disclosure may encompass a variety of aspects and/or a combination of aspects that may not be set forth.

According to an aspect of the present disclosure, a method for manufacturing an electronic package is provided. The method comprises providing a frame including a plurality of die pads, each die pad having arranged thereon a semiconductor die, the semiconductor die having a first electrical contact on a first side of the semiconductor die facing and electrically contacting the die pad, and a second electrical contact on a second side of the semiconductor die opposite to the first side; providing a first conductive mechanical support that is fixedly connected to the die pad, said first conductive mechanical support either being integrally connected to the die pad or being fixedly connected to and provided separately from the die pad, and/or providing a second conductive mechanical support that is fixedly connected to the second electrical contact and is provided separately from the die pad; providing a mold comprising a first mold portion on which the frame is arranged, and a second mold portion that is brought into contact with the frame opposite to the first mold portion, the mold forming a molding cavity around the plurality of semiconductor dies; applying a molding compound in the molding cavity and allowing said molding compound to solidify to thereby form a body that comprises the frame and solidified molding compound; and performing singulation on the body to obtain a plurality of electronic packages, each package having a first package terminal electrically connected to the first electrical contact and a second package terminal electrically connected to the second electrical contact, wherein the second mold portion contacts at least one of the first conductive mechanical support and the second conductive mechanical support while applying the molding compound and allowing said molding compound to solidify.

By providing a first conductive mechanical support and/or a second conductive mechanical support in accordance with the above, the second mold portion can have a contact point to mechanically press down the frame and thereby prevent thick flashes of molding compound from forming under the frame, in particular under the die pads.

As a result of the second mold portion contacting at least one of the first conductive mechanical support and the second conductive mechanical support while applying the molding compound and allowing said molding compound to solidify, the first conductive mechanical support and/or the second conductive mechanical support may be exposed to an outside of the body of solidified molding compound and at least partially form the first package terminal and/or the second package terminal. In other words, by physically contacting the first conductive mechanical support and/or the second conductive mechanical support with the second mold portion, it can be prevented that molding compound accumulates on (a) surface(s) thereof, enabling them to form at least part of package terminals of the electronic package.

The singulation may comprise sawing or cutting the body at a position corresponding to a position at which the second mold portion contacted the at least one of the first conductive mechanical support and the second conductive mechanical support while applying the molding compound and allowing said molding compound to solidify. For example, the position at which the second mold portion contacted the at least one of the first conductive mechanical support and the second conductive mechanical support during the molding step may be at a position not overlapping with the semiconductor dies or the die pads, i.e., in an space in between package portions. Singulating packages in this manner can save manufacturing time compared to sawing or cutting through the die pad or other portions of the body other than the solidified molding compound.

The method may further comprise removing part of the body to thereby expose a part of said at least one of the first conductive mechanical support and the second conductive mechanical support for forming at least part of the first package terminal and/or the second package terminal. For example, the conductive mechanical support(s) may include a relatively small contact area for the second mold portion, which, after removing part of the body and said conductive mechanical support(s), can expose a larger portion of said conductive mechanical support(s) for forming the first and/or second package terminal.

The second conductive mechanical support may extend beyond the semiconductor die in a direction in which the die pad and the semiconductor die face each other for allowing the second mold portion to contact it.

The second conductive mechanical support may integrally connect the die pad to an adjacent die pad among the plurality of die pads prior to performing singulation on the body. For example, the second conductive mechanical support forms part of the frame and interconnects adjacent die pads during the manufacturing process. After singulation, this interconnection may be broken.

In a further embodiment, the second electrical contact may be electrically connected to the second package terminal via an electrical interconnection such as one or more bondwires or via a clip lead, wherein the support portion is preferably integrally connected or fixedly attached to said second package terminal prior to singulation. Additionally or alternatively, the die pad may form at least part of the first package terminal. For example, the second package terminal may be a package contact included in the frame, and may optionally be integrally connected to the first conductive mechanical support.

Instead of using bondwires or a separate clip lead, the first conductive mechanical support may be a clip lead. To that end, the first conductive mechanical support may comprise a first portion fixedly attached to the second electrical contact, and a support portion integrally connected to the first portion. The support portion may extend further from the semiconductor die than the first portion for allowing the second mold portion to contact it.

In a further embodiment, the first conductive mechanical support may further comprise a second portion. The support portion may integrally connect the first portion to the second portion, and the second portion may be fixedly attached to a die pad adjacent to the die pad on which the semiconductor die is arranged to which the clip lead is fixedly attached. In other words, the first portion may be fixedly attached and electrically connected to a semiconductor die of a first package portion, and the second portion may be fixedly attached and electrically connected to a die pad of an adjacently arranged second package portion. In this case, at least part of the support portion may form at least part of the first package terminal, and at least part of the second portion forms at least part of the second package terminal.

The second mold portion may comprise one or more protruding portions at one or more positions of the first conductive mechanical support and/or the second conductive mechanical support. By changing the mold, in particular the second mold portion, the first conductive mechanical support and/or the second conductive mechanical support do not need to extend closer to second mold portion than a remainder of the package portion, though both concepts can be applied concurrently.

A plurality of said first conductive mechanical supports and/or a plurality of said second conductive mechanical supports respectively corresponding to the plurality of semiconductor dies and the plurality of die pads may be used in the method. For example, multiple, and preferably all package portions may include a first conductive mechanical support and/or a second conductive mechanical support.

The first electrical contact and/or the second electrical contact may be at least partially formed in at least one metal layer of a metal layer stack comprising one or more metal layers. In a further embodiment, the first electrical contact and/or the second electrical contact may further comprise a conductive clip or a stack of conductive clips arranged on and electrically connected to said at least one metal layer. For example, the clip(s) may each be a substantially planar metal element and may have a greater thickness than the metal layer (stack) of the first and/or second electrical contact. Said clip(s) may further aid in cooling the semiconductor die during normal operation by functioning as at least part of a heatsink.

According to another aspect of the present disclosure, an electronic package is provided. The electronic package comprises: a die pad; a semiconductor die arranged on the die pad, the semiconductor die having a first electrical contact on a first side of the semiconductor die facing and electrically contacting the die pad, and a second electrical contact on a second side of the semiconductor die opposite to the first side; a body of solidified molding compound encapsulating the semiconductor die; and a first package terminal electrically connected to the first electrical contact and a second package terminal electrically connected to the second electrical contact.

The die pad comprises a planar portion on which the semiconductor die is arranged, and a support portion integrally connected or fixedly attached to the planar portion, wherein the support portion extends beyond the semiconductor die in a direction in which the die pad and the semiconductor die face each other, said support portion having a surface exposed to an outside of the electronic package and forming at least part of the first package terminal.

The second conductive mechanical support can form the support portion of the die pad and ma. In doing so, the electronic package according to the above described aspect of the present disclosure can be manufactured without or with limited risk of thick flashes of package material forming under the die pad.

The second package terminal may be at least partially formed by a clip lead fixedly attached and electrically connected to the second electrical contact. Additionally or alternatively, the second package terminal may be electrically connected to the second electrical contact via one or more bondwires. In an example, a surface of the clip lead or the second package terminal and a surface of the support portion may be aligned in a same plane such as to enable the electronic package to be mounted to an external surface. In a further embodiment, the first electrical contact and/or the second electrical contact may be at least partially formed in at least one metal layer of a metal layer stack comprising one or more metal layers. In an even further embodiment, the first electrical contact and/or the second electrical contact may further comprise a conductive clip or a stack of conductive clips arranged on and electrically connected to said at least one metal layer.

According to yet another aspect of the present disclosure, an electronic package is provided. The electronic package comprises a die pad; a semiconductor die arranged on the die pad, the semiconductor die having a first electrical contact on a first side of the semiconductor die facing and electrically contacting the die pad, and a second electrical contact on a second side of the semiconductor die opposite to the first side; a body of solidified molding compound encapsulating the semiconductor die; and a first package terminal electrically connected to the first electrical contact and a second package terminal electrically connected to the second electrical contact.

The electronic package further comprises a clip lead comprising a first portion that is fixedly attached and electrically connected to the second electrical contact, and a second portion extending from the first portion, wherein the second portion forms at least part of the second package terminal and wherein, in a direction parallel to a direction in which the die pad faces the semiconductor die, the second portion has a first thickness near the first portion and a second thickness near an edge of the electronic package, the second thickness being less than the first thickness.

### DESCRIPTION OF THE DRAWINGS

Next, the present disclosure will be described in more detail with reference to the appended drawings, wherein:
FIG. 1 is a cross-sectional view during a known manufacturing process for electronic packages;
FIG. 2A-2D are cross-sectional views illustrating a method for manufacturing an electronic package according to an embodiment of the present disclosure;
FIG. 3A-3C are cross-sectional views illustrating a method for manufacturing an electronic package according to an embodiment of the present disclosure;
FIG. 4 is a cross-sectional view of an electronic package according to an embodiment of the present disclosure;
FIG. 5 is a cross-sectional view illustrating a method for manufacturing an electronic package according to an embodiment of the present disclosure; and
FIG. 6 is a cross-sectional view illustrating a method for manufacturing an electronic package according to another embodiment of the present disclosure.

The present disclosure is described in conjunction with the appended figures. It is emphasized that, in accordance with the standard practice in the industry, various features are not drawn to scale. In fact, the dimensions of the various features may be arbitrarily increased or reduced for clarity of discussion.

In the appended figures, similar components and/or features may have the same reference label. Further, various components of the same type may be distinguished by following the reference label by a dash and a second label that distinguishes among the similar components. If only the first reference label is used in the specification, the description is applicable to any one of the similar components having the same first reference label irrespective of the second reference label.

Unless the context clearly requires otherwise, throughout the description and the claims, the words "comprise," "comprising," and the like are to be construed in an inclusive sense, as opposed to an exclusive or exhaustive sense; that is to say, in the sense of "including, but not limited to." As used herein, the terms "connected," "coupled," or any variant thereof means any connection or coupling, either direct or indirect, between two or more elements; the coupling or connection between the elements can be physical, logical, electromagnetic, or a combination thereof. Additionally, the words "herein," "above," "below," and words of similar import, when used in this application, refer to this application as a whole and not to any particular portions of this application. Where the context permits, words in the detailed description using the singular or plural number may also include the plural or singular number respectively. The word "or," in reference to a list of two or more items, covers all of the following interpretations of the word: any of the items in the list, all of the items in the list, and any combination of the items in the list.

The teachings of the technology provided herein can be applied to other systems, not necessarily the system described below. The elements and acts of the various examples described below can be combined to provide further implementations of the technology. Some alternative implementations of the technology may include not only additional elements to those implementations noted below, but also may include fewer elements.

These and other changes can be made to the technology in light of the following detailed description. While the description describes certain examples of the technology, and describes the best mode contemplated, no matter how detailed the description appears, the technology can be practiced in many ways. Details of the system may vary considerably in its specific implementation, while still being encompassed by the technology disclosed herein. As noted above, particular terminology used when describing certain features or aspects of the technology should not be taken to imply that the terminology is being redefined herein to be restricted to any specific characteristics, features, or aspects of the technology with which that terminology is associated. In general, the terms used in the following claims should not be construed to limit the technology to the specific examples disclosed in the specification, unless the detailed description section explicitly defines such terms. Accordingly, the actual scope of the technology encompasses not only the disclosed examples, but also all equivalent ways of practicing or implementing the technology under the claims.

To reduce the number of claims, certain aspects of the technology are presented below in certain claim forms, but the applicant contemplates the various aspects of the technology in any number of claim forms.

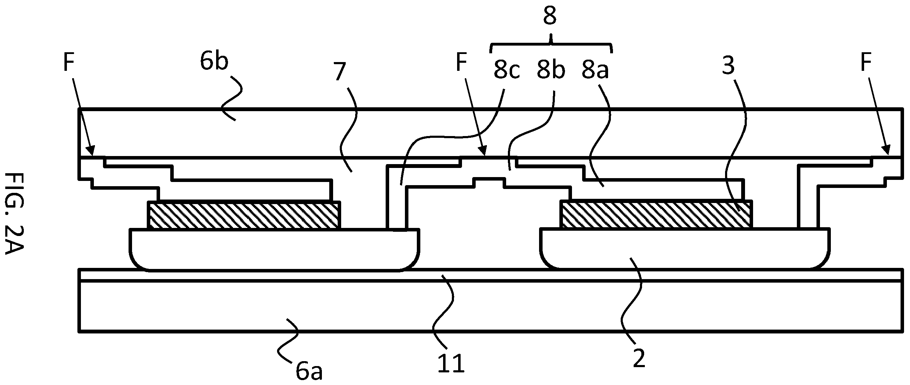

In FIG. 2A, a cross-sectional view is shown illustrating part of a method for manufacturing an electronic package. Similarly to FIG. 1, the method includes providing a frame including a plurality of die pads 2. Here, it is noted that the frame is omitted from FIG. 2A for convenience, though its arrangement may be similar to that of FIG. 1 by interconnecting various elements of the package portions such as die pads 2.

On each die pad 2, a semiconductor die 3 is provided. Semiconductor die 3 includes a first electrical contact (not shown) facing die pad 2, and a second electrical contact (not shown) opposite the first electrical contact. Here, it will be appreciated by the skilled person that the first electrical contact and the second electrical contact may each be formed in at least one metal layer of respective metal layer stacks comprising one or more such metal layers. Said metal layer stacks may be arranged on semiconductor die 3, in this case on opposite sides, and may provide electrical access to respective terminals of semiconductor die 3.

Two package portions are shown in FIG. 2A, each including a respective die pad 2 and semiconductor die 3, that will eventually form two separate electronic packages. For convenience, reference signs are only shown for one of said package portions. It is noted that, although only two package portions are shown, the method may include more than two package portions, which may be arranged in a row or array, as will be appreciated by the skilled person.

A mold is provided to arrange the package material encapsulating semiconductor dies 3. For example, the frame including die pads 2 is arranged on a first mold portion 6a, and a second mold portion 6b is provided contacting the frame to form a molding cavity 7 enclosing and surrounding the plurality of package portions. In FIG. 2A, for convenience, only part of the mold is shown, such as a middle portion where the mold does not contact the frame. An injection molding step can be applied to inject the a molding compound into molding cavity 7. The mold is arranged until the molding compound is solidified to form a solidified molding compound, after which the mold can be removed.

In the method according to an embodiment of the present disclosure, a first conductive mechanical support 8 is provided. In this example, first conductive mechanical support may be a clip lead comprising a first portion 8a fixedly attached and electrically connected to the second electrical contact of a first package portion, and a support portion 8b extending closer to second mold portion 8b than a remainder of the package portions. During the step of applying the molding compound and allowing it to solidify, second mold portion 6b is brought into contact with support portion(s) 8b at position(s) F and can exert a force thereon. In doing so, the package portion(s) corresponding to first conductive mechanical support(s) 8 is pressed down against first mold portion 6a, thereby preventing or limiting a flash of molding compound forming below said package portion.

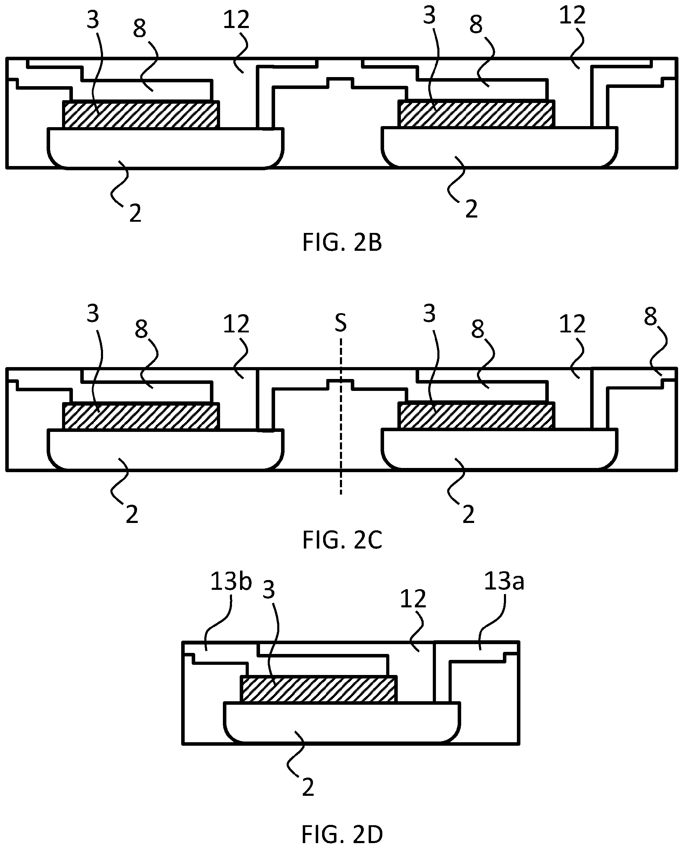

Optionally, first conductive mechanical support 8 may further include a second portion 8c which is integrally connected to support portion 8b, and is fixedly attached and electrically connected to die pad 2 of an adjacent package portion. This provides further support and downforce during molding, and enables first conductive mechanical support 8 to form a package terminal for two respective package portions, as will be discussed further below with reference to FIG. 2B-2D. However, it will be appreciated that the present disclosure is not limited thereto. Second portion 8c may instead be fixedly attached and electrically connected to another surface, such as a portion of the frame or a package terminal included in the frame, for example package contact 5 as shown in FIG. 1. In that case, such a package contact and corresponding die pad 2 may form respective package terminals of the eventual electronic package by which said electronic package can be mounted.

Die pads 2 may be stamped die pads as roughly shown in FIG. 2A, or may be etched to have a substantially flat bottom surface. Furthermore, to further decrease a likelihood of flashes forming under die pads 2, an adhesive film 11 may be provided on first mold portion 6a that adheres to die pads 2. It is noted that adhesive film 11 can be more effective when die pads 2 are etched or formed to have a substantially planar bottom surface, though this is not preferred, as etching or forming die pads 2 to have a planar bottom surface can lead to a substantial increase in manufacturing costs.

In FIG. 2B, a part of the manufacturing process after having applied the molding compound and allowing it to solidify. To that end, semiconductor dies 3 are encapsulated in solidified molding compound 12 and a body is formed comprising the package portions and solidified molding compound 12. Accordingly, since solidified molding compound 12 is formed, the mold can be removed and is thus not shown in FIG. 2B. Since second mold portion 6b contacted a surface of support portion 8b, said surface is exposed to an outside of the body.

In FIG. 2C, although optional, a portion of the body is removed to expose a larger surface area of first conductive mechanical support 8. For example, first portion 8a may be arranged at a first vertical position in the body, and support portion 8b may have a first part that is at a second vertical position in the body higher than the first vertical position, as well as a second part that was contacted by the mold and is at a third vertical position in the body higher than the second vertical position. By removing part of the body, the third part of support portion 8b is at least partially removed and the second part of support portion 8b is exposed to an outside of the body. Removing part of the body may for example be performed by a grinding or polishing operation.

In some embodiments, for example when semiconductor die 3 includes more than two terminals, the polishing operation may additionally expose further terminals of semiconductor die 3. For example, semiconductor die 3 may have a transistor integrated thereon having three terminals. The first electrical contact may be provided for a first terminal thereof, such as the drain. The second electrical contact may be provided for a second terminal thereof, such as a gate or source. Semiconductor die 3 may then further comprise a third electrical contact for a third terminal thereof, such as a source or gate, respectively, which may be arranged at a same side of semiconductor die 3 as the second electrical contact. In that case, the removal of part of the body, e.g., the grinding or polishing operation, may additionally expose the third electrical contact. This concept can be further extended to devices or circuits having more than three terminals.

The plurality of package portions are separated in a singulation step to obtain an electronic package 1 as shown in FIG. 2D. For example, a sawing or cutting action is performed along dashed line S indicated in FIG. 2C. After the singulation step, first conductive mechanical support 8 may be divided into two respective sections, each now corresponding to a different electronic package. In an example, a plurality of first conductive mechanical supports 8 are used and each package has a first section of one first mechanical support 8 corresponding to the second electrical contact of semiconductor die 3 as well as a second section of another first mechanical support 8 corresponding to die pad 2. As a result, the first and second section may each have an exposed surface that forms a first and second package terminal 13a, 13b, respectively. In embodiments where electronic package 1 only has one associated first conductive mechanical support 8, a further electrical interconnection may be provided to a separate first or second package terminal 13a, 13b.

As described above, support portion 8b may have the second part and the third part at their respective second and third vertical positions. Part of the body may be removed thereby exposing a surface of the second part to an outside of the body. As a result of the singulation operation, first and second package terminals 13a, 13b have a second thickness near an edge or periphery of electronic package 1 that is less than a first thickness away from the edge or periphery of electronic package 1. For example, package terminals 13a, 13b have the first thickness closer to semiconductor die 3.

In the embodiment shown in FIG. 2D, a surface of die pad 2 may be exposed to an outside of electronic package 1 and may act as at least part of a heatsink for semiconductor die 3. In a further embodiment, a heatsink element may be mounted to a surface of die pad 2, said heatsink element being configured to radiate heat in an outward direction with respect to electronic package 1.

First conductive mechanical support 8 may for example comprise a conductive metal such as copper. Further processing steps may be applied, such as plating package terminals 13a, 13b, for example with tin, to enable better soldering conditions.

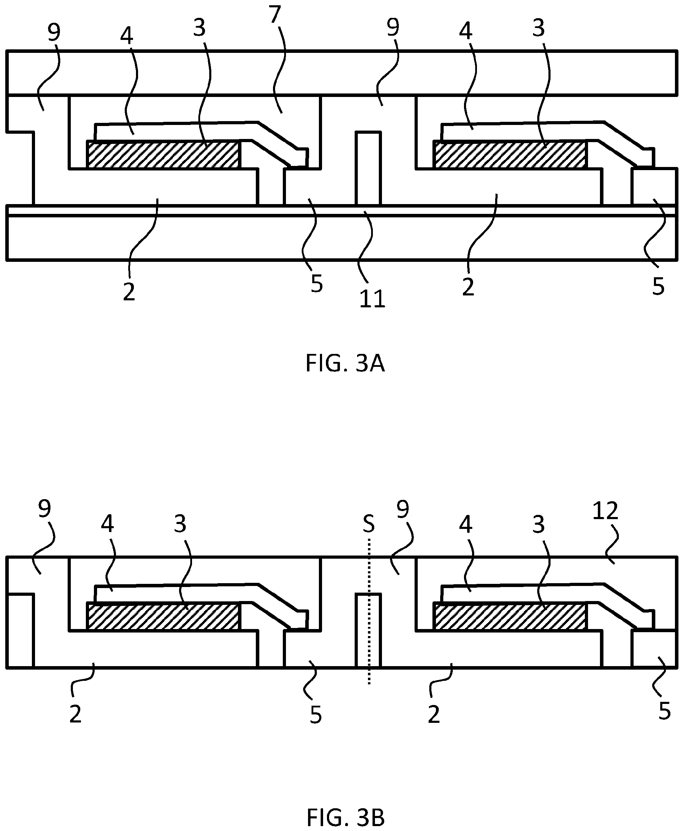

In FIG. 3A, a cross-sectional view during part of the manufacturing process according to another embodiment of the present disclosure is shown. For convenience, a step of providing the mold and forming the mold cavity is omitted from FIG. 3A. In this embodiment, a second conductive mechanical support 9 is provided. Although second conductive mechanical support 9 is shown to be integrally connected to die pad 2, the present disclosure also envisages second conductive mechanical support 9 being provided separately from die pad 2 and fixedly attached thereto during the manufacturing process.

Similarly to first conductive mechanical support 8 of FIG. 2A, second conductive mechanical support 9 in FIG. 3A extends closer to second mold portion 6b than a remainder of the corresponding package portion to allow second mold portion 6b to contact it when forming the molding cavity and during applying and solidifying molding compound. In particular, second mold portion 6b can be brought into contact with second conductive mechanical support 9 at positions F indicated in FIG. 3A to press the corresponding package portion towards first mold portion 6a at least while applying the molding compound and allowing it to solidify.

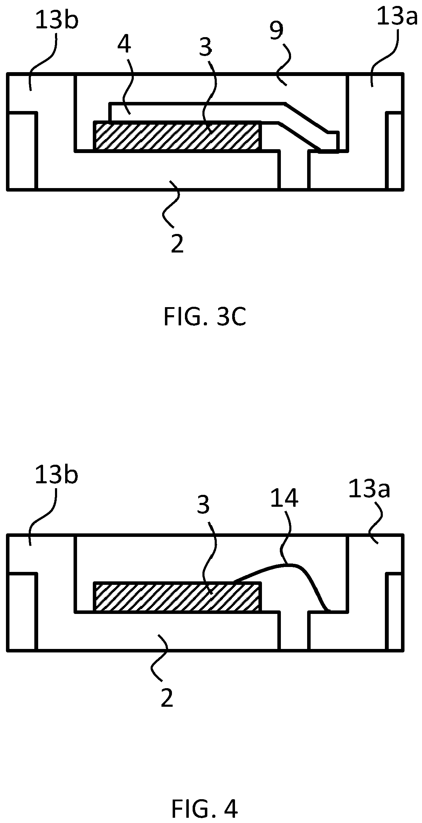

In the embodiment shown in FIG. 3A, second conductive mechanical support 9 integrally connects die pad 2 to a package contact 5 of an adjacent package portion. This integral connection is broken during singulation, as will be explained with reference to FIG. 3B and 3C. In this embodiment, a clip lead 4 is provided that is fixedly attached to the second electrical contact and to package contact 5, and electrically connects the second electrical contact to said package contact 5.

Similarly to FIG. 2A, only two package portions are shown in FIG. 3A, though the present disclosure can be applied to any number of package portions arranged in a row, array, or the like.

In FIG. 3B, a cross-sectional view of the body is shown after forming solidified molding compound 12, similarly to FIG. 2B. Singulation may be performed along dashed line S to obtain respective electronic packages 1 as shown in FIG. 3C. In this embodiment, one second conductive mechanical support 9, which is connected to die pad 2, at least partially forms first package terminal 13a, and another second conductive mechanical support 9, which is connected to package contact 5, at least partially forms second package terminal 13b.

A second conductive mechanical support 9 may be provided for multiple or each package portion of the plurality of package portions. To that end, second mold portion 6b may be brought into contact with each of said second conductive mechanical supports 9.

It is noted that both first conductive mechanical support(s) 8 of FIG. 2A-2D and second conductive mechanical support(s) 9 of FIG. 3A-3C may be used individually but may also be used concurrently. For example, some package portions may have a corresponding first conductive mechanical support, whereas other package portions have a corresponding second mechanical support. Some package portions may have a corresponding first conductive mechanical support as well as a corresponding second conductive mechanical support. In some embodiment, each package portion has at least one of a corresponding first conductive mechanical support and/or a corresponding second conductive mechanical support. When a first and/or second conductive mechanical support is used, a package portion corresponding thereto may have a package terminal at least partially formed by said first and/or second conductive mechanical support, or they may electrically connect the second electrical contact and/or first electrical contact, respectively, to a corresponding package terminal of said electronic package.

In FIG. 4, electronic package 1 is shown that differs from electronic package 1 of FIG. 3C only in a bondwire 14 instead of clip lead 4 during manufacturing. Although only one bondwire 14 is shown, a plurality of bondwires may be used to electrically interconnect the second electrical contact and package contact 5. Other types of electrical interconnection therebetween is also envisaged by the present disclosure.

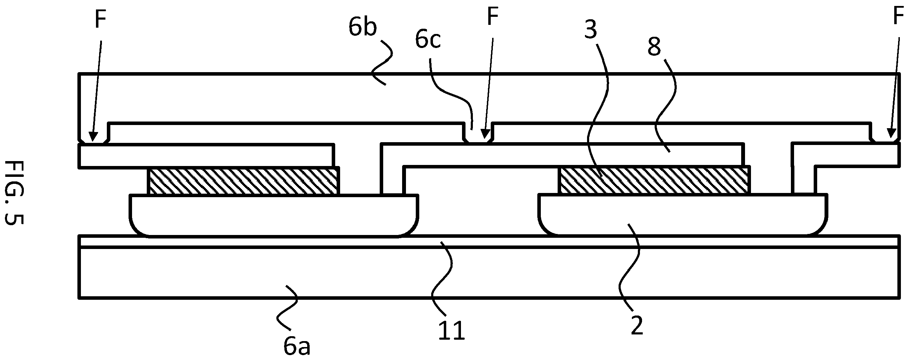

In FIG. 5, a cross-sectional view is shown illustrating part of a method for manufacturing an electronic package in accordance with an embodiment of the present disclosure. In this embodiment, first conductive mechanical support 8 corresponds to a clip lead which need not have a protruding portion extending towards second mold portion 6b. Instead, second mold portion 6b in this embodiment has a plurality of protruding mold portions 6c that extend further towards the package portions than second mold portion 6b. Preferably, said protruding mold portions 6c contact first conductive mechanical supports 8 at positions not directly above semiconductor die 3 to prevent damage when pressing second mold portion onto first conductive mechanical supports 8, for example at positions F indicated in FIG. 5.

It is noted that protruding mold portions 6c may be applied concurrently with first conductive mechanical support 8 of FIG. 2A-2D as well, and/or concurrently with second conductive mechanical support 9 of FIG. 3A-3C. For example, protruding mold portions 6c are brought into contact with each first conductive mechanical support 8 and each second conductive mechanical support, whichever is present. In particular, protruding mold portions 6c may be brought into contact with a portion of first conductive mechanical support 8 and/or second conductive mechanical support 9 extending closer to second mold portion 6b than a remainder of the corresponding package portions. In some embodiments, die pads 2 may form second conductive mechanical supports, and protruding mold portions 6c may be brought into contact with die pads 2.

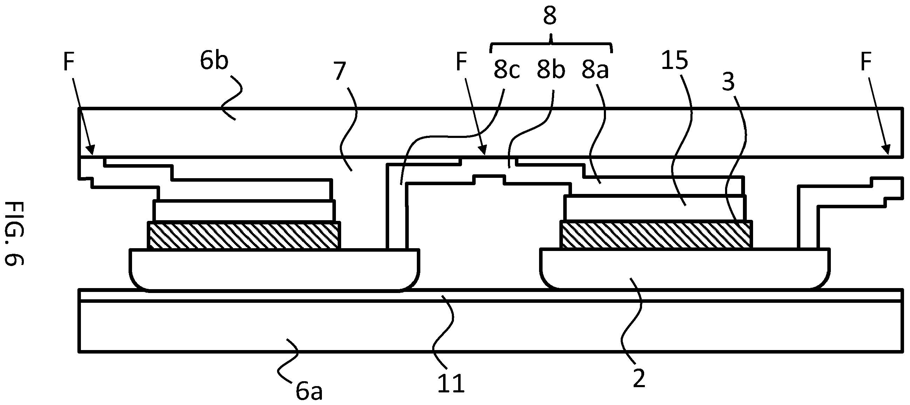

In FIG. 6, a cross-sectional view is shown illustrating part of a method for manufacturing an electronic package in accordance with an embodiment of the present disclosure. FIG. 6 differs from FIG. 2A in that at least part the second electrical contact is shown in FIG. 6. In particular, as described with reference to FIG. 2A, the first and second electrical contact may for example be formed in a corresponding metal layer stack arranged on semiconductor die 3. In this embodiment, however, second electrical contact is only partially formed in said metal layer stack, and the second electrical contact further comprises a conductive clip 15. In some embodiments, a stack of such conductive clips 15 may be used.

Conductive clip 15 may be provided in a further lead frame (not shown) during the manufacturing process, and may be fixedly attached to at least one metal layer of the metal layer stack and electrically connected to a corresponding terminal of semiconductor die 3. Conductive clip 15 (or a stack of multiple conductive clips 15) may aid in the cooling of semiconductor die 3 during operation, that is, it may at least partially function as part of a heatsink.

Although conductive clip 15 is shown to form part of the second electrical contact, its concept may similarly be applied to the first electrical contact or further terminals of semiconductor die 3. For example, conductive clip 15 may instead be provided to form at least part of the first electrical contact, or a respective conductive clip may be provided to form at least part of each of the first electrical contact, the second electrical contact, and optionally any further electrical contacts of semiconductor die 3.

Here, it is noted that the embodiments in FIG. 3-5 may similarly employ conductive clip(s) in accordance with the above for the first electrical contact and/or the second electrical contact.

In the above description, electronic packages are described that have at least two terminals. For example, semiconductor die 3 may have a circuit integrated thereon that has two terminals, such as various types of diodes or other combinations of circuits. However, the present disclosure is not limited thereto. Electronic packages according to the present disclosure, and manufacturing methods thereof, could instead have three terminals or even more than three terminals. For example, semiconductor die 3 may have a transistor integrated thereon, such as a metal-oxide-semiconductor field effect transistor (MOSFET), a bipolar junction transistor (BJT), an insulated-gate bipolar transistor (IGBT), or the like. Semiconductor die 3 may have a thyristor or silicon-controlled rectifier (SCR) integrated thereon. To that end, the electronic packages according to the present disclosure may have further package terminals and its semiconductor die may have further electrical contacts. Such electrical contacts may be electrically connected to corresponding further package terminals via further first conductive mechanical supports, or via further clips or further bondwires as appreciated by the skilled person.

Semiconductor die 3 may be based on any of silicon, silicon carbide, gallium arsenide or gallium nitride technology, or the like, as will be understood by the skilled person.

The ensuing description above provides preferred exemplary embodiment(s) only, and is not intended to limit the scope, applicability, or configuration of the disclosure. Rather, the ensuing description of the preferred exemplary embodiment(s) will provide those skilled in the art with an enabling description for implementing a preferred exemplary embodiment of the disclosure, it being understood that various changes may be made in the function and arrangement of elements, including various modifications and/or combinations of features from different embodiments, without departing from the scope of the present disclosure as defined by the appended claims.

## Claims

1. A method for manufacturing an electronic package, comprising:
providing a frame including a plurality of die pads, each die pad having arranged thereon a semiconductor die, the semiconductor die having a first electrical contact on a first side of the semiconductor die facing and electrically contacting the die pad, and a second electrical contact on a second side of the semiconductor die opposite to the first side;
providing a first conductive mechanical support that is fixedly connected to the die pad, said first conductive mechanical support either being integrally connected to the die pad or being fixedly connected to and provided separately from the die pad, and/or providing a second conductive mechanical support that is fixedly connected to the second electrical contact and is provided separately from the die pad;
providing a mold comprising a first mold portion on which the frame is arranged, and a second mold portion that is brought into contact with the frame opposite to the first mold portion, the mold forming a molding cavity around the plurality of semiconductor dies;
applying a molding compound in the molding cavity and allowing said molding compound to solidify to thereby form a body that comprises the frame and solidified molding compound; and
performing singulation on the body to obtain a plurality of electronic packages, each package having a first package terminal electrically connected to the first electrical contact and a second package terminal electrically connected to the second electrical contact,
wherein the second mold portion contacts at least one of the first conductive mechanical support and the second conductive mechanical support while applying the molding compound and allowing said molding compound to solidify.

2. The method according to claim 1, wherein, as a result of the second mold portion contacting at least one of the first conductive mechanical support and the second conductive mechanical support while applying the molding compound and allowing said molding compound to solidify, said conductive mechanical support(s) are exposed to an outside of the body of solidified molding compound and at least partially form the first package terminal and/or the second package terminal.

3. The method according to claim 1 or 2, wherein said singulation comprises sawing or cutting the body at a position corresponding to a position at which the second mold portion contacted the at least one of the first conductive mechanical support and the second conductive mechanical support while applying the molding compound and allowing said molding compound to solidify.

4. The method according to claim 3, wherein the method further comprises removing part of the body to thereby expose a part of said at least one of the first conductive mechanical support and the second conductive mechanical support for forming at least part of the first package terminal and/or the second package terminal.

5. The method according to any of the previous claims, wherein the second conductive mechanical support extends beyond the semiconductor die in a direction in which the die pad and the semiconductor die face each other for allowing the second mold portion to contact it.

6. The method according to claim 5, wherein the second conductive mechanical support integrally connects the die pad to an adjacent die pad among the plurality of die pads prior to performing singulation on the body.

7. The method according to any of the previous claims, wherein the second electrical contact is electrically connected to the second package terminal via an electrical interconnection such as one or more bondwires or via a clip lead, wherein the support portion is preferably integrally connected or fixedly attached to said second package terminal prior to singulation, and/or wherein the die pad forms at least part of the first package terminal.

8. The method according to any of claims 1-6, wherein the first conductive mechanical support is a clip lead, comprising a first portion fixedly attached to the second electrical contact and a support portion integrally connected to the first portion, wherein the support portion extends further from the semiconductor die than the first portion for allowing the second mold portion to contact it.

9. The method according to claim 8, wherein the first conductive mechanical support further comprises a second portion, wherein the support portion integrally connects the first portion to the second portion, and wherein the second portion is fixedly attached to a die pad adjacent to the die pad on which the semiconductor die is arranged to which the first conductive support portion is fixedly attached, wherein at least part of the support portion preferably forms at least part of the first package terminal or the second package terminal of the corresponding electronic package.

10. The method according to any of the previous claims, wherein the second mold portion comprises one or more protruding portions at one or more positions of the first conductive mechanical support and/or the second conductive mechanical support.

11. The method according to any of the previous claims, comprising a plurality of said first conductive mechanical supports and/or a plurality of said second conductive mechanical supports respectively corresponding to the plurality of semiconductor dies and the plurality of die pads.

12. The method according to any of the previous claims, wherein the first electrical contact and/or the second electrical contact are at least partially formed in at least one metal layer of a metal layer stack comprising one or more metal layers,
wherein, preferably, first electrical contact and/or the second electrical contact further comprises a conductive clip or a stack of conductive clips arranged on and electrically connected to said at least one metal layer.

13. An electronic package, comprising:
a die pad;
a semiconductor die arranged on the die pad, the semiconductor die having a first electrical contact on a first side of the semiconductor die facing and electrically contacting the die pad, and a second electrical contact on a second side of the semiconductor die opposite to the first side;
a body of solidified molding compound encapsulating the semiconductor die; and
a first package terminal electrically connected to the first electrical contact and a second package terminal electrically connected to the second electrical contact,
wherein the die pad comprises a planar portion on which the semiconductor die is arranged, and a support portion integrally connected or fixedly attached to the planar portion, wherein the support portion extends beyond the semiconductor die in a direction in which the die pad and the semiconductor die face each other, said support portion having a surface exposed to an outside of the electronic package and forming at least part of the first package terminal.

14. The electronic package according to claim 13, wherein the second package terminal is at least partially formed by a clip lead fixedly attached and electrically connected to the second electrical contact, or wherein the second package terminal is electrically connected to the second electrical contact via one or more bondwires,
wherein, preferably, the first electrical contact and/or the second electrical contact are at least partially formed in at least one metal layer of a metal layer stack comprising one or more metal layers,
wherein, more preferably, first electrical contact and/or the second electrical contact further comprises a conductive clip or a stack of conductive clips arranged on and electrically connected to said at least one metal layer.

15. An electronic package, comprising:
a die pad;
a semiconductor die arranged on the die pad, the semiconductor die having a first electrical contact on a first side of the semiconductor die facing and electrically contacting the die pad, and a second electrical contact on a second side of the semiconductor die opposite to the first side;
a body of solidified molding compound encapsulating the semiconductor die; and
a first package terminal electrically connected to the first electrical contact and a second package terminal electrically connected to the second electrical contact,
wherein the electronic package further comprises a clip lead comprising a first portion that is fixedly attached and electrically connected to the second electrical contact, and a second portion extending from the first portion, wherein the second portion forms at least part of the second package terminal and wherein, in a direction parallel to a direction in which the die pad faces the semiconductor die, the second portion has a first thickness near the first portion and a second thickness near an edge of the electronic package, the second thickness being less than the first thickness.
